# EUROPÄISCHE PATENTSCHRIFT

(11) **EP 1 339 895 B1**
(45) Veröffentlichungstag und Bekanntmachung des Hinweises auf die Patenterteilung: **10.06.2009**
(21) Anmeldenummer: 01992802.7
(22) Anmeldetag: 30.10.2001
(51) Int. Cl.: C23C 16/509, C23C 16/54, H01J 37/32

(54) **VERFAHREN UND VORRICHTUNG ZUR OBERFLÄCHENBEHANDLUNG ELEKTRISCH ISOLIERENDER SUBSTRATE**
METHOD AND DEVICE FOR TREATING THE SURFACE OF ELECTRICALLY INSULATING SUBSTRATES
PROCEDE ET DISPOSITIF DE TRAITEMENT DE SURFACE DE SUBSTRATS ELECTRO-ISOLANTS

(30) Priorität: 02.11.2000 DE 10054197
(43) Veröffentlichungstag der Anmeldung: 03.09.2003
(73) Patentinhaber: Fraunhofer-Gesellschaft zur Förderung der angewandten Forschung e.V., 80686 München (DE)
(72) Erfinder: KLAGES, Claus-Peter, 38102 Braunschweig (DE); JUNG, Thomas, 38173 Hötzum (DE)
(74) Vertreter: Pfenning, Meinig & Partner GbR
(86) Internationale Anmeldenummer: PCT/EP2001/012513
(87) Internationale Veröffentlichungsnummer: WO 2002/036851

(56) Entgegenhaltungen:
- DE-A- 4 233 895
- DE-A- 19 744 060
- US-A- 5 595 792

## Beschreibung

Die vorliegende Erfindung betrifft ein Verfahren und eine Vorrichtung zur Oberflächenbehandlung von elektrisch isolierenden Substraten. Derartige Verfahren und Vorrichtungen werden eingesetzt, um Substrate zu beschichten, zu reinigen, Material von ihnen abzutragen oder ihre Oberfläche zu aktivieren bzw. Gasbestandteile in die Oberflächenschicht eines Substrates einzubringen.

Insbesondere für Schutzschichten gegen mechanische, elektromagnetische und/oder chemische Einwirkungen- und dergleichen werden die erfindungsgemäßen Verfahren und Vorrichtungen verwendet.

Die Beschichtung von laufenden Polymerfolien mit Hilfe des Verfahrens der Plasmadeposition, d.h. Abscheidung von Schichten aus gas- oder dampfförmigen Verbindungen, aktiviert oder unterstützt, durch eine elektrische Gasentladung, wirft gegenüber der Beschichtung von Teilen im Batchverfahren zwei besondere Probleme auf:
1. Die hohe Bandlaufgeschwindigkeit, bei Folien heute in der Größenordnung von mehreren 100 m/min, erfordert sehr hohe stationäre Beschichtungsraten. Um etwa eine Schichtdicke von 50 nm abzuscheiden, ist bei einer Bandgeschwindigkeit von 100 m/min und einer Beschichtungszone von 1 m Länge eine stationäre Beschichtungsrate von 5 µm/min erforderlich, rund 2 Größenordnungen mehr als mit gewöhnlichen Gleich- oder Wechselstrom-Glimmentladungen erreichbar.
2. Es wird von Produktionsanlagen erwartet, daß sie mehrere Tage (Größenordnung 100 Stunden) laufen können, ohne daß eine Wartung erforderlich wäre. Voraussetzung dafür ist, daß die parasitäre Abscheidung von Schichten, d.h., Aufwachsen von Schichten an anderen Orten als.auf der Folie, in engen Grenzen gehalten wird. Es ist zu bedenken, daß in 100 h die hypothetische "stationäre" Schichtdicke auf einer ruhenden Folie bei einer Aufwachsrate von 5 µm/min 3 cm betragen würde; auch wenn die parasitäre Aufwachsrate (auf einer Gegenelektrode oder auf einem Abschirmblech oder der Gehäusewand) nur 1 % des oben angenommenen Wertes betrüge, würden mit 300 µm unakzeptabel dicke Schichlein entstehen, die infolge innerer Spannungen nicht mehr auf ihrer Unterlage haften könnten und daher in Form von abgeplatzten "Flittern" den Beschichtungsprozeß stören.

Für metallisch leitende Substrate ist eine Lösung der voranstehend beschriebenen Aufgabenstellung bereits beschrieben worden durch die DE 197 44 060 A1.

Bei dieser Lösung wird eine intensive Hohlkathodenentladung in unmittelbarer Nähe einer zu beschichtenden elektrisch leitende Folienoberfläche erzeugt, wobei die Gaszu- und abführung so gestaltet wird, daß eine Aktivierung des Gases nur in Foliennähe stattfinden kann und depositionsfähige Produkte aus der Entladungszone abgeführt werden, ohne Gelegenheit zur parasitären Ablagerung zu bekommen.

Diese Lösung läßt sich aber nicht auf isolierende Substrate oder Folien-Bänder übertragen, da diese nicht direkt elektrisch leitend kontaktiert werden können.

DE 195 30 318 A, korrespondierend zu US 5,595,792 A, zeigt eine Bechichtungsvorrichtung, bei der ein Plasmastrom zwischen zwei gegenüberliegende Oberflächen eines bandförmigen Substrates eingebracht wird. Zur Aktivierung eines reaktiven, ebenfalls zwischen die Substrate eingebrachten Gases wird über die bandförmigen Substrate und das Plasma hinweg unter Verwendung einer Hochfrequenz-Diode eine Bias-Spannung angelegt. Die Plasmaerzeugung erfolgt jedoch außerhalb des Beschichtungsbereiches. Bei dem in dieser Druckschrift beschriebenen Verfahren werden parasitäre Abscheidungen besser unterdrückt, die Beschichtungsrate ist jedoch weiterhin gering.

Aufgabe der vorliegenden Erfindung ist es, ein Verfahren und eine Vorrichtung zur Verfügung zu stellen, mit dem ein elektrisch isolierendes Substrat mit hoher Beschichtungsrate unter gleichzeitiger Unterdrükkung parasitärer Abscheidungen beschichtet werden kann.

Diese Aufgabe wird durch das Verfahren nach Anspruch, 1 sowie die Vorrichtung nach Anspruch 21 gelöst. Die Verwendung der Vorrichtung wird in Anspruch 29 beansprucht. Vorteilhafte Weiterbildungen des erfindungsgemäßen Verfahrens und der erfindungsgemäßen Vorrichtung werden in den jeweiligen abhängigen Ansprüchen 2 bis 20, 22 bis 28 und 30 gegeben.

Erfindungsgemäß werden zwei einander gegenüber positionierte, auf annähernd gleichem elektrischem Potential gegenüber einer Anode befindliche Elektroden als Hohlkathode betrieben, indem die Elektroden mit einer hochfrequenten Wechselspannung versorgt werden. Das zu beschichtende Substrat kann dabei ein auf der Elektrode befindlicher Belag oder ein abstandslos oder auch beabstandet zu den Elektroden geführtes Substrat sein. Eine Hohlkathodenentladung bildet sich insbesondere dann aus, wenn die Frequenz der Wechselspannung so hoch gewählt wird, daß die Impedanz (Wechselstromwiderstand) der isolierenden Substrate und eventuell noch vorhandener Zwischenräume zwischen den Elektroden und den isolierenden Substraten gegenüber der Impedanz der sich ausbildenden Hohlkathoden-Gasentladung klein ist.

Durch die Beaufschlagung der Elektroden mit einer Wechselspannung stellen diese selbstverständlich nur temporär Kathoden dar. Dementsprechend bilden die Elektroden auch nur temporär eine Hohlkathode. Während die Anordnung sich auf positivem Potential gegenüber der Gegenelektrode befindet, fungiert sie jedoch als Anode und die herkömmliche Anode als Kathode. Positive Aufladungen des isolierenden Substrates, werden während dieser Phase durch Elektronen vernichtet. Dennoch wird im folgenden von Hohlkathode und Anode gesprochen, wobei unter Hohlkathode, die dem Substrat benachbarten Elektroden, die eine Hohlkathodenentladung ausbilden und unter Anode die herkömmliche Gegenelektrode, die auch weit beabstandet zu den beschichteten Bereichen angeordnet sein kann, bezeichnet wird.

Als isolierende Substrate können beispielsweise Polymerfolien verwendet werden. Es kann sich um zwei separate stationäre Substrate handeln, beispielsweise um Beläge auf den Elektroden, es kann sich aber dabei auch um Bereiche von bewegten Substraten handeln, die nur kurzzeitig der Gasentladung ausgesetzt werden. Dies können beispielsweise zwei Folien sein oder auch zwei separate Bereiche von ein und demselben Substrat, z.B. einer Polymerfolie.

Die Ausbildung einer Hohlkathoden-Glimmentladung wird vorteilhafterweise bei Abständen von ca. 5 cm und einem Druck von ca. 1 mbar zwischen den zu beschichtenden Bereichen erreicht. Die Entladung einer Hohlkathodenentladung ist wesentlich intensiver als eine gewöhnliche Glimmentladung, da eine um Größenordnungen höhere Ionisation erhalten wird (sogenannter Hohlkathodeneffekt). Mit einer Hohlkathodenentladung, insbesondere Hohlkathoden-Glimmentladung, werden daher wesentlich höhere Beschichtungsraten bzw. im Falle einer Reinigung Abtragsraten erzielt.

Durch geeignete Anordnung der Zufuhr des Edelgases bzw. der reaktiven Gase kann eine uniforme Reinigung bzw. Beschichtung über die volle Breite des Substrates möglich werden. Durch das Prinzip der Hohlkathode wird erreicht, daß das reaktive Gas nur in der gewünschten Zone aktiviert wird und dadurch parasitäre Abscheidungen weitestgehend unterdrückt werden. Die Bildung eines Plasmas und gegebenenfalls die Aktivierung der reaktiven Gase erfolgt lediglich in unmittelbarer Nähe zu den Elektroden und damit zu den zu behandelnden Bereichen des Substrates.
Im folgenden werden einige Beispiele erfindungsgemäßer Vorrichtungen und Verfahren beschrieben.

Es zeigen
- Fig. 1: eine erfindungsgemäße Vorrichtung; und
- Fig. 2: eine weitere erfindungsgemäße Vorrichtung.

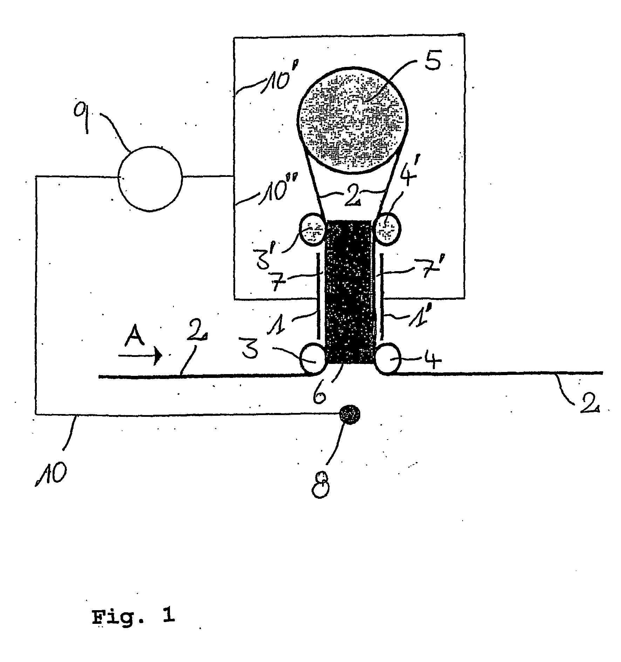

In diesen Beispielen wird eine Polymerfolie gemäß der Erfindung beschichtet. In Fig. 1 wird hierzu eine Polymerfolie 2 in Pfeilrichtung A über Umlenkrollen 3, 3'_{,} 5, 4', 4 transportiert. Die Umlenkrollen, 3, 3', und 4, 4' sind so angeordnet, daß die Folie zwischen den Umlenkrollen 3, 3' parallel zu der Folie wischen den Umlenkrollen 4, 4' geführt wird. Zwischen diesen beiden Rollen 3, 3' bzw. 4, 4' ist jeweils eine Elektrode 1, 1' mit ihren Oberflächen parallel zu der Folie 2 und mit einem Zwischenraum 7, 7' beabstandet zu diesen angeordnet. Beide Elektroden 1, 1' werden von einer Spannungsquelle 9 (Hochfrequenz-Generator) über Leitungen -10', 10" mit derselben Spannung beaufschlagt. Außerhalb der Anordnung der Rollen 3, 3', 4, 4' befindet sich eine Anode 8, die über eine Leitung 10 mit der entsprechenden Gegenspannung der Hochfrequenz aus dem Generator 9 versorgt wird. Bei Auswahl einher geeigneten Frequenz der Hochfrequenzspannungwird der Wechselstromwiderstand des isolierenden Substrates 2 und der Zwischenräume 7, 7' zwischen den Elektroden 1, 1' und den Substraten 2 kleiner als die Impedanz der sich dann ausbildenden HohlkathodenEntladung 6 in einem Gasentladungsbereich, der im wesentlichen durch die Ausdehnung der Elektroden 1, 1' definiert ist.

Die Folie 2 kann nicht nur, so wie in Fig. 1 gezeigt, beabstandet zu den Elektroden 1, 1' geführt werden, sondern es ist auch möglich, diese in unmittelbarer Berührung zu der Oberfläche der Elektroden 1, 1' zu führen oder Substrate zu behandeln oder zu beschichten, die als Belag auf die Elektroden 1, 1' aufgebracht sind. In letzterem Falle entfallen dann selbstverständlich die Transportmechanismen für die Folie 2, insbesondere die Umlenkrollen 3, 3', 5, 4', 4.

Bei dieser Anordnung brennt folglich die Hohlkathodenentladung in dem Hohlraum, der durch die Walzen 3, 3', 4', 4 demarkiert ist.

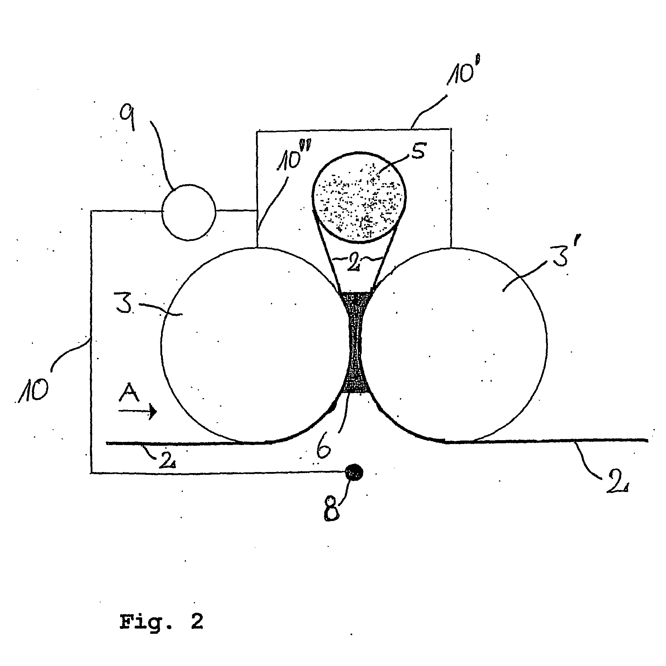

Fig. 2 zeigt eine weitere erfindungsgemäße Vorrichtung, wobei hier mit gleichen oder ähnlichen Bezugszeichen gleiche oder ähnliche Elemente bezeichnet sind. In diesem Falle wird die Folie 2 über drei Umlenkrollen 3, 5, 3' geführt, wobei die Umlenkrollen 3, 3' selbst als Elektroden mit einer Hochfrequenz-Spannung über die Leitungen 10', 10" von der Hochfrequenz-Quelle 9 beaufschlagt werden. In diesem Falle werden die Folien auf den Umlenkrollen 3, 3' geführt, so daß sie unmittelbar kapazitiv an die'als , Elektroden vorhandenen Umlenkrollen 3, 3' gekoppelt sind. Es bildet sich auch hier wiederum zwischen den Rollen 3, 3' und in einem durch die Rollen 3, 3' definierten Bereich während der entsprechenden Polarität der Spannung der Rollen 3, 3' eine Hohlkathoden-Glimmentladungszone 6 aus. In dieser Zone 6 wird das Substrat 2 bei jedem Durchlauf behandelt, beispielsweise gereinigt, Material abgetragen oder bei Zufuhr eines Reaktivgases beschichtet.

Zwischen den Rollen wird eine Polymerfolie mit 30 µm -Dicke mit einer Geschwindigkeit von 50 m/min gleichmäßig bewegt. In den Hohlkathodenbereich wird ein Gasgemisch, bestehend aus 40 % Ethin und 60 % Argon eingeleitet. Der Totaldruck im Hohlkatodenbereich beträgt 0,3 hPa (mbar). An die Rollen wird eine Wechselspannung mit einer Frequenz von 150 kHz und einer effektiven Amplitude von 300 V angelegt. Diese Wechselspannung erzeugt eine Hohlkathoden-Glimmentladung, die das Ethin chemisch aktiviert, und bewirkt gleichzeitig einen Ionenbeschuß der Folienoberfläche. Dadurch kommt es zu einer innigen Vernetzung der sich auf der Folienoberfläche niederschlagenden Ethin-Fragmente, und es entsteht eine amorphe Kohlenstoffschicht. Die Dicke der Kohlenstoffschicht beiträgt, 0,1 µm, ihre Härte 20 GPa.

## Patentansprüche

1. Verfahren zur Oberflächenbehandlung von mindestens einem elektrisch isolierenden Substrat mit Hilfe einer Hohlkathoden-Glimmentladung, wobei je zwei zu behandelnde Oberflächenbereiche des oder der Substrate beabstandet zueinander angeordnet und kapazitiv an eine Spannungsquelle gekoppelt werden, **dadurch gekennzeichnet, daß** an'die zu behandelnden Oberflächenbereiche eine Spannung derart angelegt wird, daß diese gleiche Polarität aufweisen und sich zwischen den zu behandelnden Oberflächenbereichen sowie durch diese an zumindest zwei im wesentlichen gegenüberliegenden Seiten begrenzt eine Hohlkathoden-Glimmentladung ausbildet.

2. Verfahren nach dem vorhergehenden Anspruch, **dadurch gekennzeichnet, daß** an die zu behandelnden Oberflächenbereiche eine Spannung derart angelegt wird, daß diese gleiches oder fast gleiches Potential besitzen.

3. Verfahren nach einem der vorhergehenden Ansprüche, **dadurch gekennzeichnet, daß** die je zwei zu behandelnden Oberflächenbereiche in geringem Abstand zueinander parallel oder nahezu parallel zueinander angeordnet werden.

4. Verfahren nach einem der vorhergehenden Ansprüche, **dadurch gekennzeichnet, daß** der Abstand zwischen 1 mm und 50 cm beträgt.

5. Verfahren nach einem der vorhergehenden Ansprüche, **dadurch gekennzeichnet, daß** mit einem elektrisch isolierenden Substrat beschichtete Elektroden behandelt werden.

6. Verfahren nach einem der Ansprüche 1 bis 4, **dadurch gekennzeichnet, daß** bandförmige Substrate behandelt werden, wobei die zu behandelnden Oberflächenbereiche jeweils zu mindestens einer Elektrode beabstandet oder diese berührend angeordnet oder geführt werden.

7. Verfahren nach dem vorhergehenden Anspruch, **dadurch gekennzeichnet, daß** ein oder mehrere, fortlaufend geförderte Substrate zumindest bereichsweise den Entladungsbereich begrenzend geführt werden.

8. Verfahren nach dem vorhergehenden Anspruch, **dadurch gekennzeichnet, daß** das mindestens eine geförderte Substrat zur Änderung der Förderrichtung mindestens einmal umgelenkt wird und der Entladungsbereich auf mindestens einer Seite durch in Förderrichtung vor der mindestens einen Umlenkung und auf mindestens einer weiteren Seite durch in Förderrichtung nach der mindestens einen Umlenkung liegende Substratbereiche begrenzt wird.

9. Verfahren nach einem der vorhergehenden Ansprüche, **dadurch gekennzeichnet, daß** der Gasdruck ihm Bereich zwischen den je zwei zu behandelnden Oberflächen zwischen 0,01 hPa (mbar) und 100 hPa (mbar) eingestellt wird.

10. Verfahren nach einem der vorhergehenden Ansprüche, **dadurch gekennzeichnet, daß** zwischen die zwei zu behandelnden Oberflächen ein mindestens ein Edelgas enthaltendes oder daraus bestehendes Gas eingebracht wird.

11. Verfahren nach dem vorhergehenden Anspruch, **dadurch gekennzeichnet, daß** als Edelgas Argon eingebracht wird.

12. Verfahren nach einem der vorhergehenden Ansprüche, **dadurch gekennzeichnet, daß** zwischen die zwei zu behandelnden Oberflächen ein oder mehrere reaktive Gase eingebracht werden.

13. Verfahren nach dem vorhergehenden Anspruch, **dadurch gekennzeichnet, daß** als reaktives Gas oxidierende, reduzierende, kohlenstoffhaltige oder siliziumhaltige Verbindung eingebracht werden.

14. Verfahren nach einem der beiden vorhergehenden Ansprüche, **dadurch gekennzeichnet, daß** als reaktives Gas Sauerstoff, Wasserstoff, Stickstoff, Methan, Ethin, Silan, Hexamethyldisoloxan und/oder Tetramethylsilan eingebracht wird.

15. Verfahren nach einem der vorhergehenden Ansprüche, **dadurch gekennzeichnet, daß** eine Spannung mit einer Frequenz zwischen 10 kHz bis 10 GHz angelegt wird.

16. Verfahren nach dem vorhergehenden Anspruch, **dadurch gekennzeichnet, daß** eine Spannung mit einer Frequenz zwischen 1 MHz und 100 MHz angelegt wird.

17. Verfahren nach einem der vorhergehenden Ansprüche, **dadurch gekennzeichnet, daß** eine Spannung angelegt wird mit einer Frequenz, bei der die Impedanz (Wechselstromwiderstand) des Substrats und gegebenenfalls der zwischen den Elektroden und dem Substrat befindlichen Zwischenräume kleiner ist als die Impedanz des Plasmas der Gasentladung.

18. Verfahren nach einem der vorhergehenden Ansprüche, **dadurch gekennzeichnet, daß** eine Spannung zwischen 1 V und 3000 V angelegt wird.

19. Verfahren nach einem der vorhergehenden Ansprüche, **dadurch gekennzeichnet, daß** die zu behandelnden Oberflächen eben sind.

20. Verfahren nach einem der vorhergeheden Ansprüche, **dadurch gekennzeichnet, daß** das mindestens eine Substrat ein fortlaufend gefördertes Band ist, das von einer ersten Spule abwickelbar und auf eine zweite Spule aufwickelbar ist.

21. Vorrichtung zur Durchführung eines Verfahrens nach einem der vorhergehenden Ansprüche, mit einer Vakuumkammer, einer mit der Vakuumkammer verbundenen Vakuumpumpe,
einer Vorrichtung zur Halterung und/oder Führung des mindestens einen Substrates in der Vakuumkammer derart, daß durch mindestens zwei zu behandelnde, voneinander beabstandete Oberflächenbereiche des Substrates ein Entladungsbereich definiert ist,
mindestens einer Gaseinspeisung zur Einspeisung von Gas in den Entladungsbereich, sowie mindestens einer Gasabführung aus der Vakuumkammer,
**gekennzeichnet durch**
eine Vorrichtung zur kapazitiven Übertragung von Energie an die zu behandelnden Oberflächenbereiche des mindestens einen Substrats, wobei die Vorrichtung zur kapazitiven Übertragung von Energie eine Spannungsquelle zum Anlegen einer Spannung gleicher Polarität an die zu behandelnden Oberflächenbereiche aufweist, so dass das Substrat eine Hohlkathode bildet.

22. Vorrichtung dem vorhergehenden Anspruch, **dadurch gekennzeichnet, daß** die Vorrichtung zur kapazitiven Übertragung von Energie Elektroden aufweist, die den zu behandelnden Oberflächenbereichen benachbart angeordnet oder mit diesen beschichtet sind.

23. Vorrichtung nach einem der Ansprüche 21 bis 24, **dadurch gekennzeichnet, daß** die mindestens zwei zu behandelnden Oberflächenbereiche zwischen 1 mm und 50 cm voneinander beabstandet sind.

24. Vorrichtung nach einem der Ansprüche 21 bis 25, **dadurch gekennzeichnet, daß** die Gasabführung aus der Vakuumkammer derart angeordnet ist, daß durch sie Gase unmittelbar aus dem Entladungsbereich absaugbar sind.

25. Vorrichtung nach einem der Ansprüche 21 bis 26, **gekennzeichnet durch** eine erste Spule zum Abwickeln des mindestens einen Substrates und eine zweite Spule zum Aufwickeln des mindestens einen Substrates.

26. Vorrichtung nach dem vorhergehenden Anspruch, **dadurch gekennzeichnet, daß** die Spulen zum Auf- und Abwickeln des mindestens einen Substrates außerhalb der Vakuumkammer angeordnet sind und Vakuumschleusen zum Ein- und Ausführen des mindestens einen Substrates in die und aus der Vakuumkammer vorgesehen sind.

27. Vorrichtung nach Anspruch 27, **dadurch gekennzeichnet, daß** die Spulen zum Auf- und Abwickeln des mindestens einen Substrates innerhalb der Vakuumkammer angeordnet sind.

28. Vorrichtung nach einem der Ansprüche 28 und 29, **dadurch gekennzeichnet, daß** in der Vakuumkammer eine Umlenkrolle angeordnet ist derart, daß das Substrat einen ersten und einen zweiten zu behandelnden Bereich bildet und dazwischen über die Umlenkrolle bzgl. seiner Orientierung und Bewegungsrichtung umlenkbar ist.

29. Verwendung einer Vorrichtung nach einem der vorhergehenden Ansprüche zum Beschichten, Reinigen, Materialabtragen und/oder Aktivieren von Substratoberflächen oder zum Integrieren von Gasbestandteilen in ein Substrat bzw. dessen Oberflächenschicht.

30. Verwendung nach dem vorhergehenden Anspruch zum Beschichten mit einer Schutzschicht gegen mechanische, elektromagnetische und/oder chemische Einwirkungen, einer Permeationsbarriere, einer Haftschicht, einer dekorativen Schicht und/oder einer optischen Funktionsschicht.

## Claims

1. A method of treating the surface of at least one electrically insulating substrate with the aid of a hollow-cathode glow discharge, wherein two surface regions - to be treated - of the substrate or substrates are arranged in each case at a distance from each other and are coupled capacitively to a voltage source, **characterized in that** a voltage is applied in such a way to the surface regions to be treated that they have the same polarity and a hollow-cathode glow discharge is formed in a limited manner on at least two substantially opposed sides between the surface regions to be treated as well as through them.

2. A method according to the preceding Claim, **characterized in that** a voltage is applied in such a way to the surface regions to be treated that they have an equal or virtually an equal potential.

3. A method according to one of the preceding Claims, **characterized in that** the two respective surface regions to be treated are arranged at a slight distance from each other and parallel or virtually parallel to each other.

4. A method according to any one of the preceding Claims, **characterized in that** the distance amounts to between 1 mm and 50 cm.

5. A method according to any one of the preceding Claims, **characterized in that** electrodes coated with an electrically insulating substrate are treated.

6. A method according to any one of Claims 1 to 4, **characterized in that** strip-shaped substrates are treated, wherein the surface regions to be treated are arranged or conveyed in each case at a distance from at least one electrode or touching the latter.

7. A method according to the preceding Claim, **characterized in that** one or more continuously advanced substrates are conveyed bounding the discharge region at least locally.

8. A method according to the preceding Claim, **characterized in that** the at least one advanced substrate is reversed at least once in order to change the advancing direction, and the discharge region is bounded on at least one side by substrate regions situated upstream of the at least one reversal in the advancing direction and on at least one further side by substrate regions situated downstream of the at least one reversal in the advancing direction.

9. A method according to any one of the preceding Claims, **characterized in that** the gas pressure in the region between the two surfaces to be treated in each case is set between 0.01 hPa (mbar) and 100 hPa (mbar).

10. A method according to any one of the preceding Claims, **characterized in that** a gas containing at least one noble gas or consisting of the latter is introduced between the two surfaces to be treated.

11. A method according to the preceding Claim, **characterized in that** argon is introduced as the noble gas.

12. A method according to any one of the preceding Claims, **characterized in that** one or more reactive gases is or are introduced between the two surfaces to be treated.

13. A method according to the preceding Claim, **characterized in that** oxidizing, reducing, carbon-containing or silicon-containing compound[s] are introduced as a reactive gas.

14. A method according to one of the two preceding Claims, **characterized in that** oxygen, hydrogen, nitrogen, methane, acetylene, silane, hexamethyldisoloxane and/or tetramethylsilane is or are introduced as a reactive gas.

15. A method according to any one of the preceding Claims, **characterized in that** a voltage with a frequency of between 10 kHz [and] 10 GHz is applied.

16. A method according to the preceding Claim, **characterized in that** a voltage with a frequency of between 1 MHz and 100 MHz is applied.

17. A method according to any one of the preceding Claims, **characterized in that** a voltage is applied with a frequency at which the impedance (alternating-current resistance) of the substrate and optionally of the interspaces present between the electrodes and the substrate is lower than the impedance of the plasma of the gas discharge.

18. A method according to any one of the preceding Claims, **characterized in that** a ' voltage of between 1 V and 3000 V is applied.

19. A method according to any one of the preceding Claims, **characterized in that** the surfaces to be treated are level.

20. A method according to any one of the preceding Claims, **characterized in that** the at least one substrate is a continuously advanced strip which is capable of being unwound from a first spool and of being wound up onto a second spool.

21. An apparatus for performing a method according to any one of the preceding Claims, with a vacuum chamber,
a vacuum pump connected to the vacuum chamber,
an apparatus for retaining and/or conveying the at least one substrate in the vacuum chamber in such a way that a discharge region is defined by at least two surface regions of the substrate which are to be treated and which are arranged at a distance from each other,
at least one gas feed-in means for feeding gas into the discharge region, and at least one gas discharge means out of the vacuum chamber,
**characterized by**
an apparatus for the capacitive transmission of energy to the surface regions - to be treated - of the at least one substrate, wherein the apparatus for the capacitive transmission of energy has a voltage source for applying a voltage of equal polarity to the surface regions to be treated, so that the substrate forms a hollow cathode.

22. An apparatus according to the preceding Claim, **characterized in that** the apparatus for the capacitive transmission of energy has electrodes which are arranged adjacent to the surface regions to be treated or are coated with the latter.

23. An apparatus according to any one of Claims 21 to 24 [*sic*]*,* **characterized in that** the at least two surface regions to be treated are arranged at a distance of between 1 mm and 50 cm from each other.

24. An apparatus according to any one of Claims 21 to 25 [sic], **characterized in that** the gas discharge means out of the vacuum chamber is arranged in such a way that gases are capable of being drawn directly out of the discharge region through it.

25. An apparatus according to any one of Claims 21 to 26 [sic], **characterized by** a first spool for unwinding the at least one substrate and a second spool for winding up the at least one substrate.

26. An apparatus according to the preceding Claim, **characterized in that** the spools for winding up and unwinding the at least one substrate are arranged outside the vacuum chamber, and vacuum locks for introducing and removing the at least one substrate into and from the vacuum chamber are provided.

27. An apparatus according to Claim 27 [*sic*], **characterized in that** the spools for winding up and unwinding the at least one substrate are arranged inside the vacuum chamber.

28. An apparatus according to one of Claims 28 and 29 [*sic*]*,* **characterized in that** a reversing roll is arranged in the vacuum chamber in such a way that the substrate forms a first and a second region to be treated and is capable of being reversed with respect to its orientation and direction of movement between them by way of the reversing roll.

29. Use of an apparatus according to any one of the preceding Claims for the coating, cleaning, removal of material and/or activation of substrate surfaces or for the integration of gas constituents into a substrate or the surface layer thereof respectively.

30. Use according to the preceding Claim for the coating with a layer to protect against mechanical, electromagnetic and/or chemical action, a permeation barrier, an adhesive layer, a decorative layer and/or an optical function layer.

## Revendications

1. Procédé de traitement de surface d'au moins un substrat électroisolant à l'aide d'une décharge lumineuse par cathode creuse, dans lequel, respectivement, deux zones de surface à traiter du ou des substrats sont agencées à distance l'une de l'autre et couplées à une source de tension par voie capacitive, **caractérisé en ce qu'**on applique sur les zones de surface à traiter une tension telle que celles-ci présentent la même polarité et qu'il se forme entre les zones de surface à traiter ainsi qu'à travers celles-ci sur au moins deux faces sensiblement opposées de manière limitée une décharge lumineuse par cathode creuse.

2. Procédé selon la revendication précédente, **caractérisé en ce qu'**on applique sur les zones de surface à traiter une tension telle que celles-ci possèdent un potentiel identique ou presque identique.

3. Procédé selon l'une quelconque des revendications précédentes, **caractérisé en ce que** respectivement deux zones de surface à traiter sont agencées à faible distance l'une de l'autre parallèlement ou presque parallèlement l'une à l'autre.

4. Procédé selon l'une quelconque des revendications précédentes, **caractérisé en ce que** la distance est comprise entre 1 mm et 50 cm.

5. Procédé selon l'une quelconque des revendications précédentes, **caractérisé en ce que** des électrodes revêtues d'un substrat électroisolant sont traitées.

6. Procédé selon l'une quelconque des revendications 1 à 4, **caractérisé en ce que** l'on traite des substrats en forme de bandes, dans lequel les zones de surface traiter sont respectivement à distance d'au moins une électrode ou sont agencées ou guidées en contact avec celles-ci.

7. Procédé selon la revendication précédente, **caractérisé en ce qu'**un ou plusieurs substrats acheminés en continu est ou sont guidés au moins par zones de manière à limiter la zone de décharge.

8. Procédé selon la revendication précédente, **caractérisé en ce que** le au moins un substrat acheminé est soumis à un changement de direction au moins une fois pour modifier la direction d'acheminement et la zone de décharge est délimitée par des zones de substrat se trouvant, au moins sur une face, dans la direction d'acheminement en amont du au moins un changement de direction et, sur au moins une autre face, dans la direction d'acheminement en aval du au moins un changement de direction.

9. Procédé selon l'une quelconque des revendications précédentes, **caractérisé en ce que** la pression de gaz dans la zone entre les, respectivement, deux surfaces à traiter est réglée entre 0,01 hPa (mbar) et 100 hPa (mbars).

10. Procédé selon l'une quelconque des revendications précédentes, **caractérisé en ce qu'**un gaz contenant au moins un gaz rare ou constitué d'un tel gaz rare est introduit entre les deux surfaces à traiter.

11. Procédé selon l'une quelconque des revendications précédentes, **caractérisé en ce qu'**on introduit de l'argon comme gaz rare.

12. Procédé selon l'une quelconque des revendications précédentes; **caractérisé en ce qu'**on introduit un ou plusieurs gaz réactifs entre les deux surfaces à traiter.

13. Procédé selon la revendication précédente, **caractérisé en ce que** l'on introduit comme gaz réactif un composé oxydant, réducteur, carboné ou contenant du silicium.

14. Procédé selon l'une quelconque des deux revendications précédentes, **caractérisé en ce que** l'on introduit comme gaz réactif de l'oxygène, de l'hydrogène, de l'azote, du méthane, de l'acétylène, du silane, de l'hexaméthyldisoloxane et/ou du tétraméthylsilane.

15. Procédé selon l'une quelconque des revendications précédentes, **caractérisé en ce qu'**une tension d'une fréquence de 10 kHz à 10 GHz est appliquée.

16. Procédé selon la revendication précédente, **caractérisé en ce qu'**une tension d'une fréquence de 1 MHz à 100 MHz est appliquée.

17. Procédé selon l'une quelconque des revendications précédentes, **caractérisé en ce que** l'on applique une tension d'une certaine fréquence, dans lequel l'impédance (résistance en courant alternatif) du substrat et, éventuellement, des espaces intermédiaires se trouvant entre les électrodes et le substrat est plus petite que l'impédance du plasma de la décharge de gaz.

18. Procédé selon l'une quelconque des revendications précédentes, **caractérisé en ce que** l'on applique une tension entre 1 V et 3000 V.

19. Procédé selon l'une quelconque des revendications précédentes, **caractérisé en ce que** les surfaces à traiter sont planes.

20. Procédé selon l'une quelconque des revendications précédentes, **caractérisé en ce que** le au moins un substrat est une bande acheminée en continu qui peut être déroulée d'une première bobine et enroulée sur une seconde bobine.

21. Dispositif pour réaliser un procédé selon l'une quelconque des revendications précédentes, comprenant
une chambre à vide,
une pompe à vide reliée à la chambre à vide,
un dispositif de maintien et/ou de guidage du au moins un substrat dans la chambre à vide de sorte qu'une zone de décharge soit définie par au moins deux zones de surface à traiter espacées l'une de l'autre,
au moins une alimentation en gaz pour alimenter en gaz la zone de décharge, ainsi qu'au moins une évacuation de gaz hors de la chambre à vide,
**caractérisé par**
un dispositif de transfert capacitif d'énergie sur les zones de surface à traiter du au moins un substrat, le dispositif de transfert capacitif d'énergie présentant une source de tension pour appliquer une tension de même polarité sur les zones de surface à traiter de sorte que le substrat forme une cathode creuse.

22. Dispositif selon la revendication précédente, **caractérisé en ce que** le dispositif de transfert capacitif d'énergie présente des électrodes qui sont agencées au voisinage des zones de surface à traiter ou sont revêtues de celles-ci.

23. Dispositif selon l'une quelconque des revendications 21 à 24, **caractérisé en ce que** les au moins deux zones de surface à traiter sont espacées l'une de l'autre de 1 mm à 50 cm.

24. Dispositif selon l'une quelconque des revendications 21 à 25, **caractérisé en ce que** l'évacuation de gaz hors de la chambre à vide est agencée de manière que les gaz puissent être aspirés hors de la zone de décharge par cette évacuation.

25. Dispositif selon l'une quelconque des revendications 21 à 26, **caractérisé par** une première bobine pour dérouler le au moins un substrat et une seconde bobine pour enrouler le au moins un substrat.

26. Dispositif selon la revendication précédente, **caractérisé en ce que** les bobines d'enroulement et de déroulement du au moins un substrat sont agencées à l'extérieur de la chambre à vide et il est prévu des sas de vide pour introduire le au moins un substrat dans la chambre à vide et l'en évacuer.

27. Dispositif selon la revendication 27, **caractérisé en ce que** les bobines d'enroulement et de déroulement du au moins un substrat sont aménagés à l'intérieur de la chambre à vide.

28. Dispositif selon l'une quelconque des revendications 28 et 29, **caractérisé en ce que** l'on agence dans la chambre à vide un rouleau de changement de direction de sorte que le substrat forme une première et une seconde zone à traiter et puisse changer de direction entre elles sur le rouleau de changement de direction par rapport à son orientation et sa direction de déplacement.

29. Utilisation d'un dispositif selon l'une quelconque des revendications précédentes pour revêtir, nettoyer, extraire du matériau et/ou activer des surfaces de substrat ou pour intégrer des composants de gaz à un substrat ou à sa couche de surface.

30. Utilisation selon la revendication précédente pour revêtir d'une couche de protection contre les effets mécaniques, électromagnétiques et/ou chimiques, une barrière à la perméation, une couche adhésive, une couche décorative et/ou une couche fonctionnelle optique.
